Europäisches Patentamt

European Patent Office

Office européen des brevets

(19)

(11) Veröffentlichungsnummer: **0 365 717**
**A1**

## (12) EUROPÄISCHE PATENTANMELDUNG

(21) Anmeldenummer: 88309067.2

(22) Anmeldetag: 29.09.88

(51) Int. Cl.⁵: **H03M 1/12**

(43) Veröffentlichungstag der Anmeldung:
02.05.90 Patentblatt 90/18

(84) Benannte Vertragsstaaten:
AT BE CH DE FR GB IT LI LU NL SE

(71) Anmelder: **Siemens Aktiengesellschaft
Österreich
Siemensstrasse 88 - 92
A-1210 Wien(AT)**

(72) Erfinder: **Bustance, David C.
Craig Cottage 15 Fowlmere Road
Royston Hertfordshire(GB)**
Erfinder: **Lidbetter, Paul
76 Chapel Lane
Fowlmere Royston Hertfordshire(GB)**
Erfinder: **Douglas, Stephen
8 Orwell Road
Barrington Cambridge CB2 5SE(GB)**
Erfinder: **Kempson, David
18b Ivel Gardens
Biggleswade Bedfordshire SG18 0AN(GB)**

(54) Verfahren und Vorrichtung zur Wandlung eines analogen Eingangssignales.

(57) Ein Eingangssignal (ES) wird in einen 20-Bit-Ausgangswert (AW) in Exponentialdarstellung gewandelt. Dazu wird ein erster multiplizierender Digital/Analog-Wandler (MDAC1) über einen Exponentenwert (EW) als digital gesteuerter Verstärker eines aus dem Eingangssignal (ES) gebildeten Abtastsignals (AS) verwendet. Der Exponentenwert (EW) wird während des Abtastens des Eingangssignals (ES) erzeugt und damit die Verstärkungsstufe kontinuierlich eingestellt. Der Exponentenwert (EW) ist eine Näherung des Abtastsignals (AS) und bildet den Exponenten des Ausgangswertes (AW). Er wird in einem Ausgangsspeicher (OL) mit dem aus dem Abtastsignal (AS) gebildeten Mantissenwert (MW) zusammengeführt.

Fig. 1

Fig. 2

## Verfahren und Vorrichtung zur Wandlung eines analogen Eingangssignales

Die Erfindung betrifft ein Verfahren zur Wandlung eines analogen Eingangssignales, das während einer Abtastperiode eines Arbeitszyklus abgetastet wird, wobei dieses Abtastsignal gehalten und in einen digitalen Exponentenwert gewandelt wird, mit dem eine Verstärkungsstufe für das Abtastsignal eingestellt wird, wobei dieses Verstärkersignal gleichfalls abgetastet, gehalten und während des Haltens in einen digitalen Mantissenwert umgewandelt wird, der zusammen mit dem Exponentenwert zu einem Ausgangswert in Exponentialdarstellung zusammengefügt wird und wobei während des Haltens des Verstärkersignals bereits das Eingangssignal im nächsten Arbeitszyklus abgetastet wird.

Nach einem derartigen Verfahren arbeitet der Analog/Digital-Wandler für Exponentialdarstellung, der in "Electronic Design", Vol. 32/No. 18, Seite 175 - 186 vom 6. Sept. 1984, beschrieben wird. Wenn die Verstärkungsstufe aus dem vorangegangenen Arbeitszyklus auf einen großen Verstärkungsfaktor eingestellt ist, kann das folgende Abtastsignal den Ausgang der Verstärkungsstufe überladen und dadurch das Halten des Verstärkersignals aus dem vorangegangenen Arbeitszyklus unterbrechen. Dies wird dadurch verhindert, daß die Verstärkungsstufe auf Null gesetzt wird, während das Verstärkersignal gehalten wird. Dazu wird ein zusätzlicher Schaltkreis und ein Steuerintervall benötigt.

Der Erfindung liegt die Aufgabe zugrunde, die Verwendung dieses Schaltkreises zu erübrigen.

Dies wird gemäß Patentanspruch 1 dadurch erreicht, daß der Exponentenwert bereits während des Abtastens des Eingangssignales erzeugt und damit die Verstärkungsstufe kontinuierlich eingestellt wird.

Der Verstärkungsfaktor der Verstärkungsstufe folgt immer dem Pegel des Abtastsignals, und die Verstärkungsstufe wird selbsttätig kalibriert. Dadurch steht mehr Zeit zur Verfügung, die Verstärkungsstufe exakt einzustellen. Der notwendige Verstärkungsfaktor ändert sich von Arbeitszyklus zu Arbeitszyklus im allgemeinen nur wenig und muß lediglich um den Differenzwert angepaßt werden.

Zur Erzielung eines möglichst linearen Verstärkungsverhaltens wird der Exponentenwert vor dem Einstellen der Verstärkungsstufe und der Zusammenfügung mit dem Ausgangswert auf eine kleinere Bitzahl umcodiert und es werden weniger als die Hälfte der möglichen Werte vom Exponentenwert angenommen Der Verzicht auf die Umwandlung aller durch die Exponentialdarstellung möglichen Zwischenwerte erhöht die Linearität beträchtlich und senkt den Rauschpegel ab.

Eine Durchführung des Verfahrens wird dadurch ermöglicht, daß ein erstes Abtast-Halteglied eingangsseitig mit einem Analogeingang, ausgangsseitig sowohl mit einem den Exponentenwert bildenden Parallel-A/D-Wandler als auch mit einem das Verstärkersignal bildenden ersten multiplizierenden D/A-Wandler verbunden ist, daß der Digitalausgang des Parallel-A/D-Wandlers über einen Kodierer sowohl mit dem Digitaleingang des ersten multiplizierenden D/A-Wandlers, als auch mit einem den Ausgangswert bildenden Ausgangsspeicher verbunden ist und daß der Analogausgang des ersten multiplizierenden D/A-Wandlers über ein zweites Abtast-Halteglied mit dem Analogeingang eines Mantissen-A/D-Wandlers verbunden ist, dessen Ausgangsleitungen mit dem Ausgangsspeicher verbunden sind. Das erste Abtast-Halteglied hält die Spannung des Eingangssignals zur Wandlung durch den Parallel-A/D-Wandler konstant. Währenddes sen ändert der multiplizierende D/A-Wandler erforderlichenfalls den Verstärkungsfaktor. Die rasche Parallelwandlung des Eingangssignals verhindert, daß der multiplizierende D/A-Wandler bei großen Signaländerungen überladen wird.

Um das erfindungsgemäße Prinzip auch bei der Rückwandlung des Ausgangswertes anzuwenden, ist es vorteilhaft, daß die den Mantissenwert haltenden Plätze eines Eingangsspeichers mit dem Digitaleingang eines Mantissen-D/A-Wandlers und die den Exponentenwert haltenden Plätze des Eingangsspeichers mit einem Dekodierer verbunden sind, daß einem zweiten multiplizierenden D/A-Wandler die Werte des Dekodierers und das Ausgangssignal des Mantissen-D/A-Wandlers zugeführt sind und der Ausgang des zweiten multiplizierenden D/A-Wandlers über einen Glättungsfilter mit einem Analogausgang verbunden ist.

Die Erfindung wird anhand eines Ausführungsbeispieles mit zwei Abbildungen näher erläutert. Es zeigen:

Fig. 1 ein Blockschaltbild der Analog/Digital-Wandlerbaugruppe und

Fig. 2 ein Blockschaltbild der Digital/Analog-Wandlerbaugruppe des Ausführungsbeispieles.

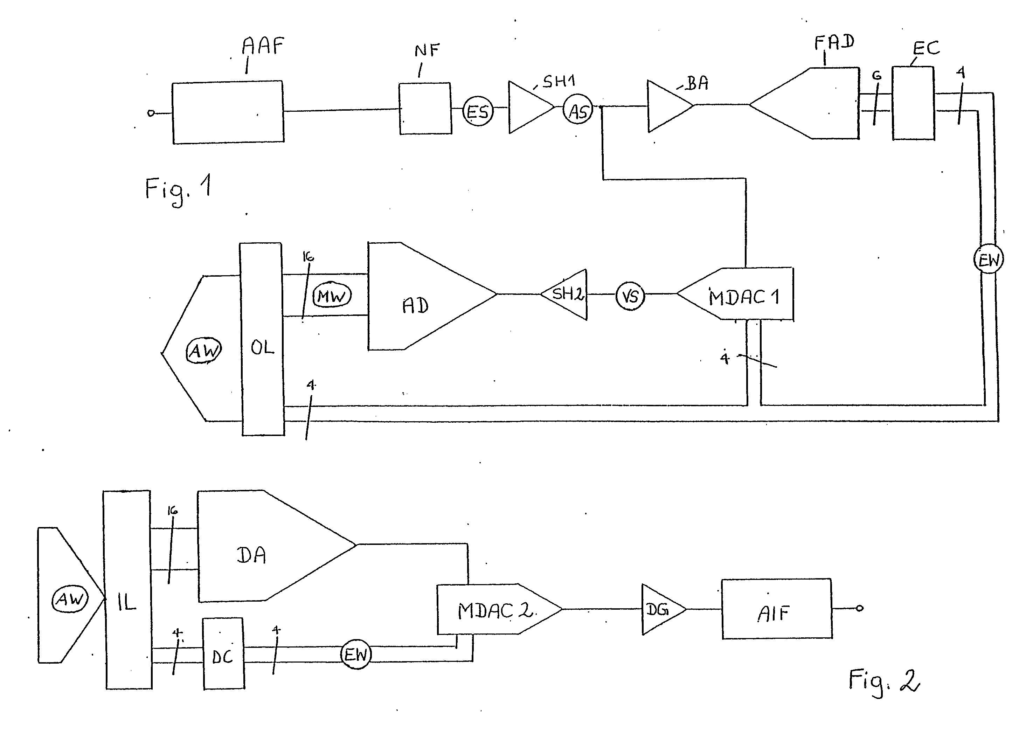

Als Ausführungsbeispiel wird die Wandlung eines analogen Audiosignals in einen 20-Bit Ausgangswert AW und seine Rückwandlung beschrieben. Der Ausgangswert AW wird als Tonwert in Exponentialdarstellung digital weiterverarbeitet. Wie Fig. 1 zeigt, ist der Eingangsfilter der Analog/Digital-Wandlerbaugruppe aus einem Echofilter AAF und einem Breitbandfilter NF aufgebaut. Der Echofilter AAF ist ein Tiefpaßfilter, dessen Rauschanteile oberhalb von 24 kHz vom Breitbandfilter NF zur Senkung des gesamten Rauschpegels entfernt werden. Als Breitbandfilter NF wird ein Butterworth-Filter verwendet, der ein besonders gutes Durchgangsverhalten aufweist.

Ein derart gefiltertes Eingangssignal ES wird einem ersten Abtast-Halteglied SH1 zugeleitet. Zur Vermeidung von Verzerrungen bei hohem Signalpegel werden Haltekondensatoren mit einer Kapazität von 1 nF verwendet. Des Eingangssignal ES wird mit 48 kHz in ein Abtastsignal AS umgewandelt. Die Abtastperiode eines Arbeitszyklus beginnt, während noch im Endbereich der Baugruppe der Ausgangswert AW des vorangegangenen Zyklus zusammengestellt wird. In der Halteperiode folgen die Arbeitsschritte von Bauteilen, die zwischen dem ersten Abtast-Halteglied SH1 und einem zweiten Abtast-Halteglied SH2 angeordnet sind. Ein Vorspannungsverstärker BA ist mit dem Ausgang des ersten Abtast-Halteglieds SH1 verbunden, um den Spannungsbereich für einen Parallel-A/D-Wandler FAD anzupassen. Der Parallel-A/D-Wandler FAD arbeitet während der Abtastperiode des ersten Abtast Haltegliedes SH1 kontinuierlich und hält den Wert am Digitalausgang während der Halteperiode. Der Parallel-A/D-Wandler FAD erzeugt in etwa 300 ns einen 6-Bit Wert, der von einem Kodierer EC in einen 4-Bit Exponentenwert EW in Hexadezimaldarstellung umgewandelt wird. Dieser Exponentenwert EW stellt bereits den Exponentialanteil des 20-Bit Ausgangswertes AW der Baugruppe dar und wird einem Ausgangsspeicher OL zugeleitet.

Darüberhinaus ist der Ausgang des Kodierers EC auch noch mit dem Digitaleingang eines ersten multiplizierenden D/A-Wandler MDAC1 verbunden. Dieser erste multiplizierende D/A-Wandler MDAC1 verfügt über einen 12-Bit Eingang, es werden aber zur besseren Linearität nur 5 Stufen genutzt. Die Auflösung des Audiosignals entspricht damit einer linearen 20-Bit Wandlung. Ein Analogeingang des ersten multiplizierenden D/A-Wandlers MDAC1 ist mit dem ersten Abtast-Halteglied SH1 verbunden. Die Schaltung ist so aufgebaut, daß ein Verstärkungssignal VS am Ausgang des ersten multiplizierenden D/A-Wandlers MDAC1 ansteigt, wenn der Exponentenwert EW absinkt. Sind alle Bits des Exponentenwertes EW gleich 1, so beträgt auch der Verstärkungsfaktor 1. In den übrigen Verstärkungsstufen ist zur besseren Unterscheidbarkeit immer nur jeweils ein Bit gleich 1.

Die Änderung eines Bits ändert den Verstärkungsfaktor um 6 dB. Der Exponentenwert EW fungiert als Eingangswiderstand des ersten multiplizierenden D/A-Wandlers MDAC1 bei extern fixierter Verstärkung. Ein dabei mögliches Ansteigen der Quantisierungsverzerrung wird dadurch vermieden, daß ein Rückkopplungskondensator verwendet wird. Bei einem 6-Bit Exponentenwert EW wäre dieser Rückkopplungskondensator bei kleiner Verstärkung zuschaltbar auszuführen. In diesem Fall wäre auch zu beachten, daß der Kondensator nicht überladen wird und Spannungsspitzen erzeugt. Der erste multiplizierende D/A-Wandler MDAC1 arbeitet somit als digital gesteuerter Verstärker. Er kontrolliert das Abtastsignal AS des ersten Abtast-Haltegliedes SH1.

Der Ausgang des ersten multiplizierenden D/A-Wandlers MDAC1 ist mit dem zweiten Abtast-Halteglied SH2 verbunden. Dieses hält am Ausgang das Signal, während der Parallel-A/D-Wandler FAD und der erste multiplizierende D/A-Wandler MDAC1 das Abtastsignal AS des folgenden Arbeitszylkus bearbeiten. Ein 16-Bit Mantissen-A/D-Wandler AD wandelt währenddessen das vom zweiten Abtast-Halteglied SH2 gehaltene Signal in einen Mantissenwert MW als Teil des Ausgangswertes AW um. Der Mantissenwert MW wird im Ausgangsspeicher OL mit dem Exponentenwert EW zusammengeführt. Dabei ist zu beachten, daß der Exponentenwert EW doppelt gepuffert wird, da der Kodierer EC eine Periode im Arbeitszyklus voran ist.

Die Verwendung des zweiten Abtast-Haltegliedes SH2 vergrößert die Zeitspanne, die zur Durchführung der Wandlungsoperationen zur Verfügung steht. Während durch den Mantissen-A/D-Wandler AD ein Wandlungszyklus abgeschlossen wird, beginnt das erste Abtast-Halteglied SH1 bereits mit dem Abtasten des Eingangssignales ES für den Folgenden Zyklus. Durch diesen Zeitgewinn werden zum Aufbau der Abtast-Halteglieder SH1, SH2 keine besonderen Operationsverstärker benötigt, und es genügen Standardtypen (beispielsweise 5534). Bei direkter Verbindung des ersten multiplizierenden D/A-Wandlers MDAC1 mit dem Mantissen-A/D-Wandler AD könnten Störungen am Ausgang des ersten multiplizierenden D/A-Wandlers MDAC1 die Qualität der gesamten Analog/Digital-Wandlung stark vermindern.

Das zweite Abtast-Halteglied SH2 ist mit einer besonders stabilisierten Spannungsversorgung verbunden, da der Abtast-Halteübergang empfindlich und ein exaktes Rücksetzen in diesem Teil der Baugruppe wichtig ist. Die Temperatureinflüsse auf den Abast-Halteübergang werden bereits durch die Kondensatoren von 1 nF herabgesetzt. Deren Kapazität ist höher, als sonst bei Abtast-Haltegliedern üblich. Als Mantissen-A/D-Wandler AD wird ein gängiger 16-Bit Wandler verwendet. Er ist so getaktet, daß er die zur Verfügung stehende Wandlungszeit maximal ausnützt. Um auch hier Störspannungen zu verhindern, ist der Mantissen-A/D-Wandler AD gleichfalls mit der stabilisierten Spannungsversorgung verbunden.

Bei der Rückwandlung wird der Ausgangswert AW von einem in Fig. 2 dargestellten Eingangsspeicher IL der Digital/Analog-Wandlerbaugruppe gehalten. Die Mantisse von 16 Bit wird von einem Mantissen-D/A-Wandler DA umgewandelt, ohne daß dabei der Exponent berücksichtigt wird. Um das Ausgangssignal möglichst rauschfrei zu halten, wird bei einem Wandler vom Typ MP 7545 der Strom- statt des Spannungsausgangs verwendet. Ein Stabilisierungsstrom wird zur Justierung dem Anschluß an virtuelle Erde zugeleitet.

Ein zweiter multiplizierender D/A-Wandler MDAC2 entspricht dem in der Analog/Digital-Wandlerbaugruppe verwendeten. Nur 5 der möglichen Eingangsstufen werden genutzt. Zu jedem Zeitpunkt hat nur immer jeweils eines der Bits des Exponentenwertes EW den Wert 1. Anstelle der Verstärkung wird im zweiten multiplizierenden D/A-Wandler MDAC2 eine Dämpfung eingestellt. Je kleiner der über einen Dekodierer DC zugeführte Exponent ist, desto größer wird die Dämpfung. Im Dekodierer DC wird der Exponent aus dem Hexadezimalsystem umcodiert.

Ein Glättungsfilter DG hält das Ausgangssignal während der Mantissen-D/A-Wandler DA und der zweite multiplizierende D/A Wandler MDAC2 das Ausgangssignal des nächsten Arbeitszyklus wandeln. Dadurch werden Spannungsspitzen vermieden. Ein Ausgangsfilter AIF entfernt alle Signalanteile oberhalb von 24 kHz und bestimmt wesentlich den Rauschpegel der Digital/Analog-Wandlerbaugruppe.

Gleichstromspitzen können im Digitalbereich der Wandlerbaugruppen empfindliche Störungen verursachen. Sie machen sich als Quantisierungsverzerrung bemerkbar, wenn der Ausgangswert AW in ein analoges Signal rückgewandelt wird. Das Auftreten von Gleichstromspitzen muß insbesondere im Bereich zwischen dem ersten und zweiten multiplizierenden D/A-Wandler MDAC1, MDAC2 verhindert werden. Außerhalb dieses Bereichs sind sie tolerierbar, da sie beim Einstellen der Verstärkungsstufe ausgeglichen werden.

Der Rauschpegel der Wandlerbaugruppen beträgt etwa -80 dBu, die Frequenzkonstanz ist besser als +/-0,3 dB von 20 Hz - 20 kHz und die Verzerrung bei +18 dBu ist kleiner als 0,04 % (-67 dB) von 20 Hz - 20 kHz. Die Verbesserung gegenüber herkömmlichen 16-Bit Systemen beträgt beim Rauschpegel mehr als 10 dB, bei der Signalrückwandlung mehr als 24 dB und bei der Verzerrung etwa 10 dB.

## Ansprüche

1. Verfahren zur Wandlung eines analogen Eingangssignales (ES), das während einer Abtastperiode eines Arbeitszyklus abgetastet wird, wobei dieses Abtastsignal (AS) gehalten und in einen digitalen Exponentenwert (EW) gewandelt wird, mit dem eine Verstärkungsstufe für das Abtastsignal (AS) eingestellt wird, wobei dieses Verstärkersignal (VS) gleichfalls abgetastet, gehalten und während des Haltens in einen digitalen Mantissenwert (MW) umgewandelt wird, der zusammen mit dem Exponentenwert (EW) zu einem Ausgangswert (AW) in Exponentialdarstellung zusammengefügt wird und wobei während des Haltens des Verstärkersignals (VS) bereits das Eingangssignal (ES) im nächsten Arbeitszyklus abgetastet wird, dadurch gekennzeichnet, daß der Exponentenwert (EW) bereits während des Abtastens des Eingangssignales (ES) erzeugt und damit die Verstärkungsstufe kontinuierlich eingestellt wird.

2. Verfahren nach Anspruch 1, dadurch gekennzeichnet, daß der Exponentenwert (EW) vor dem Einstellen der Verstärkungsstufe und der Zusammenfügung mit dem Ausgangswert (AW) auf eine kleinere Bitzahl umcodiert wird und weniger als die Hälfte der möglichen Werte vom Exponentenwert (EW) angenommen werden

3. Vorrichtung zur Durchführung des Verfahrens nach Anspruch 1 oder 2, dadurch gekennzeichnet, daß ein erstes Abtast-Halteglied (SH1) eingangsseitig mit einem Analogeingang, ausgangsseitig sowohl mit einem den Exponentenwert (EW) bildenden Parallel-A/D-Wandler (FAD) als auch mit einem das Verstärkersignal (VS) bildenden ersten multiplizierenden D/A-Wandler (MDAC1) verbunden ist, daß der Digitalausgang des Parallel-A/D-Wandlers (FAD) über einen Kodierer (EC) sowohl mit dem Digitaleingang des ersten multiplizierenden D/A-Wandlers (MDAC1), als auch mit einem den Ausgangswert (AW) bildenden Ausgangsspeicher (OL) verbunden ist und daß der Analogausgang des ersten multiplizierenden D/A-Wandlers (MDAC1) über ein zweites Abtast-Halteglied (SH2) mit dem Analogeingang eines Mantissen-A/D-Wandlers (AD) verbunden ist, dessen Ausgangsleitungen mit dem Ausgangsspeicher (OL) verbunden sind.

4. Vorrichtung zur Rückwandlung des Ausgangswertes (AW), dadurch gekennzeichnet, daß die den Mantissenwert (MW) haltenden Plätze eines Eingangsspeichers (IL) mit dem Digitaleingang eines Mantissen-D/A-Wandlers (DA) und die den Exponentenwert (EW) haltenden Plätze des Eingangsspeichers (IL) mit einem Dekodierer (DC) verbunden sind, daß einem zweiten multiplizierenden D/A-Wandler (MDAC2) die Werte des Dekodierers (DC) und das Ausgangssignal des Mantissen-D/A-Wandlers (DA) zugeführt sind und der Ausgang des zweiten multiplizierenden D/A-Wandlers (MDAC2) über einen Glättungsfilter (DG) mit einem Analogausgang verbunden ist.

Fig. 1

Fig. 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | JOURNAL OF THE AUDIO ENGINEERING SOCIETY, Band 33, Nr. 10, Oktober 1985, Seiten 770-781; New York, US L.D. FIELDER: " The audibility of modulation noise in floating-point conversion systems" | | H 03 M 1/12 |
| | * Figur 1; Seite 771, linke Spalte, Zeilen 26-30, rechte Spalte, Zeile 27 - Seite 772, linke Spalte, Zeile 6, Zeilen 36-42; Seite 778, linke Spalte, Zeilen 1-10,29-33; Seite 779, rechte Spalte, Zeile 3 - Seite 780, rechte Spalte, Zeile 12 * | 4 | |
| A | | 1-3 | |
| A | ELEKTRONIK, Band 31, Nr. 3, Februar 1982, Seiten 78-80; München, DE G. HEINLE: "Gleitkomma-D/A-Umsetzer verrringter Quantisierungsfehler" | | |
| | | | RECHERCHIERTE SACHGEBIETE (Int. Cl.4) |
| | * Figur 2; Seite 79, rechte Spalte, Zeile 26 - Seite 80, linke Spalte, Zeile 20 * | 4 | H 03 M |
| A,D | ELECTRONIC DESIGN, Band 32, Nr. 18, 6. September 1984, Seiten 175-186; Hasbrouck Height, US R. BURRIER et al.: "Floating-point converter uses hardware to get a 20-bit dynamic range" | | |

| Recherchenort | Abschlußdatum der Recherche | Prüfer |
|---|---|---|
| DEN HAAG | 23-05-1989 | DE LA FUENTE |

Europäisches
Patentamt

## GEBÜHRENPFLICHTIGE PATENTANSPRÜCHE

Die vorliegende europäische Patentanmeldung enthielt bei ihrer Einreichung mehr als zehn Patentansprüche.

☐ Alle Anspruchsgebühren wurden innerhalb der vorgeschriebenen Frist entrichtet. Der vorliegende europäische Recherchenbericht wurde für alle Patentansprüche erstellt.

☐ Nur ein Teil der Anspruchsgebühren wurde innerhalb der vorgeschriebenen Frist entrichtet. Der vorliegende europäische Recherchenbericht wurde für die ersten zehn sowie für jene Patentansprüche erstellt für die Anspruchsgebühren entrichtet wurden,

nämlich Patentansprüche:

☐ Keine der Anspruchsgebühren wurde innerhalb der vorgeschriebenen Frist entrichtet. Der vorliegende europäische Recherchenbericht wurde für die ersten zehn Patentansprüche erstellt.

## X | MANGELNDE EINHEITLICHKEIT DER ERFINDUNG

Nach Auffassung der Recherchenabteilung entspricht die vorliegende europäische Patentanmeldung nicht den Anforderungen an die Einheitlichkeit der Erfindung; sie enthält mehrere Erfindungen oder Gruppen von Erfindungen, nämlich:

1. Patentansprüche 1-3: A/D Wandlungsverfahren

2. Patentanspruch 4: Vorrichtung zur D/A Wandlung

☐ Alle weiteren Recherchengebühren wurden innerhalb der gesetzten Frist entrichtet. Der vorliegende europäische Recherchenbericht wurde für alle Patentansprüche erstellt.

☐ Nur ein Teil der weiteren Recherchengebühren wurde innerhalb der gesetzten Frist entrichtet. Der vorliegende europäische Recherchenbericht wurde für die Teile der Anmeldung erstellt, die sich auf Erfindungen beziehen, für die Recherchengebühren entrichtet worden sind,

nämlich Patentansprüche:

☒ Keine der weiteren Recherchengebühren wurde innerhalb der gesetzten Frist entrichtet. Der vorliegende europäische Recherchenbericht wurde für die Teile der Anmeldung erstellt, die sich auf die zuerst in den Patentansprüchen erwähnte Erfindung beziehen,

nämlich Patentansprüche: 1-3